# EUROPEAN PATENT APPLICATION

(11) **EP 2 378 107 A1**
(43) Date of publication of application: **19.10.2011**
(21) Application number: 10160355.3
(22) Date of filing: 19.04.2010
(51) Int. Cl.: F02M 51/06, F02M 63/00, H01L 41/053

(54) **Actuator arrangement for use in a fuel injector**

(71) Applicant: Delphi Technologies Holding S.à.r.l., 4940 Bascharage (LU)
(72) Inventor: Leblay, Arnaud, 54620 Beuveille (FR); Aye, Andreas, 8033 Strassen (LU)
(74) Representative: Gregory, John David Charles

(57) **Abstract**

The present invention relates to an actuator arrangement for use in a fuel injector, comprising: a piezoelectric actuator having a body section, said body section having a first end piece and a second end piece; a rigid encapsulation member which encloses the body section and the end pieces, wherein potting material is fitted between the rigid encapsulation member and the body section, wherein the first end piece is slideably fitted into the rigid encapsulation and the second end piece is fixed to or integrated into the encapsulation member.

## Description

### Technical field

The present invention relates to an actuator arrangement for use in a fuel injector of the type intended for use in a fuel system of an internal combustion engine. The invention relates, more particularly, to an end-seal of an actuator arrangement of a fuel injector of the accumulator or common rail type, the fuel injector being of the type controlled using a piezoelectric actuator.

### Background Art

It is known to use piezoelectric actuators in fuel injectors of internal combustion engines. Such piezoelectrically operable fuel injectors provide a high degree of control over the timing of injection events within the combustion cycle and the volume of fuel that is delivered during each injection event. This permits improved control over the combustion process, which is essential in order to keep pace with increasingly stringent worldwide environmental regulations. Such fuel injectors may be employed in compression ignition (diesel) engines or spark ignition (petrol) engines.

A typical piezoelectric actuator unit designed for use in an automotive fuel injector has a stack structure formed from an alternating sequence of piezoelectric elements or layers and planar internal electrodes. The piezoelectric layers, in turn, form an alternating sequence of oppositely polarised layers, and the internal electrodes form an alternating sequence of positive and negative internal electrodes. The positive internal electrodes are in electrical connection with a first external electrode, hereinafter referred to as the positive side electrode. Likewise, the internal electrodes of the negative group are in electrical connection with a second external electrode, hereinafter referred to as the negative side electrode.

If a voltage is applied between the two external electrodes, the resulting electric fields between each adjacent pair of positive and negative internal electrodes cause each piezoelectric layer, and therefore the piezoelectric stack, to undergo a strain along its length, i.e. along an axis normal to the plane of each internal electrode. Because of the polarisation of the piezoelectric layers, it follows that not only can the magnitude of the strain be controlled by adjusting the applied voltage, but also the direction of the strain can be reversed by switching the polarity of the applied voltage. Rapidly varying the magnitude and/or polarity of the applied voltage causes rapid changes in the strength and/or direction of the electric fields across the piezoelectric layers, and consequentially rapid variations in the length of the piezoelectric actuator. Typically, the piezoelectric layers of the stack are formed from a ferroelectric material such as lead zirconate titanate (PZT).

Such an actuator is suitable for use in a fuel injector, for example of the type known from the present Applicant's European Patent No. EP 0995901. The fuel injector is arranged so that a change in length of the actuator results in a movement of a valve needle. The needle can be thus raised from or lowered onto a valve seat by control of the actuator length so as to permit a quantity of fuel to pass through drillings provided in the valve seat.

In use, the actuator of such a fuel injector is surrounded by fuel at high pressure. The fuel pressure may be up to or above 2000 bar. In order to protect the piezoelectric actuator from damage and potential failure, the piezoelectric actuator must be isolated from this environment by at least a layer of barrier material, herein referred to as 'encapsulation member'. It is known to encapsulate the piezoelectric actuator with an inert fluoropolymer, for example as described in the Applicant's PCT published Patent Application No. WO02/061856A1 (EP 1356529 A), which acts to prevent permeation of liquid fuel, water and contaminant substances dissolved in the water or fuel, into the structure of the actuator.

A further piezoelectric actuator suitable for use in an automotive fuel injector, comprising a device body bearing encapsulation member to protectively encapsulate the device body wherein the encapsulation member includes several organic layers and at least one metal layer is known from the Applicant's published PCT Patent Application No. WO2007093921 A.

It has been observed, however, that there may still be ingress of fluid into the interface between the actuator and the polymeric sleeve.

It is known to provide a filler material, as described, for example, in the Applicant's co-pending application WO 02/061856, between the coating and the encapsulated actuator in an attempt to limit the ingress of fluid between the coating and the actuator. However, this requires filling the entire space defined between the coating and the actuator with a curable substance, and may also require a degassing step, which adds to the complexity of the actuator arrangement and the method of assembly.

It has been found that in the known encapsulations, the seal of the organic polymer sleeve at both ends of the actuator provides a weak spot as well as the encapsulation itself allowing over time the infiltrations of liquids such as diesel fuel, rapeseed methyl ester (RME) based fuels and water into the actuator and that further efforts are needed to ensure a better encapsulation at reasonable costs. It is indeed often a matter of time and temperature, as to when fuel or other liquids will permeate through the end seals of the encapsulation means leading to fatal component failure of the piezoelectric actuator and, thus, the fuel injector as a whole. Different solutions to this problem have already been proposed.

The applicant has experimented with a number of methods of encapsulating piezoelectric stacks covered with a passivation material, attempting to reduce the permeation of fuel and/or water. One method currently being investigated by the applicant to achieve this function is the use of a polymeric heat shrink material made out of a fluoropolymer. Alternatively, it has been proposed to overmould the piezoelectric actuator with a thermoplastic polymer.

It has also been proposed to encapsulate the actuator in a shape memory metallic material like a nickel titanium alloy such as that manufactured by Johnson Matthey under the trade name NITINOL (Nickel Titanium Naval Ordnance Laboratory). Alloying additions such as iron may be included in order to modify the transformation temperature of the shape memory alloy. Other shape memory alloys based on copper may be used, but nickel titanium alloys are preferred for their superelastic shape memory characteristics. The machined shape memory metallic tube has a wall thickness of less than one millimeter and preferably between about 200 to 500 microns. Subsequently, the original shape memory metallic tube is plastically deformed below its transformation temperature, for example by inserting a mandrel into the tube to stretch the tube, such that the inner tube area becomes larger than the actual piezoelectric stack surface area, thus allowing the tube to be placed over and cover the stack and anywhere else necessary to isolate the passivation material. Stretching the tube by about 4% from its original shape will usually be sufficient to permit insertion of the stack. Then, by heating the deformed shape memory metallic tube, on the piezoelectric stack, above its transformation temperature, for example to approximately 220°C, the tube recovers its original shape. After heating, the metallic tube fits to the dimensions of the passivated piezoelectric stack and preferably also its end pieces, effectively hermetically sealing the tube on to the end pieces.

In a further method, it has been proposed to use a metal tube around the piezoelectric actuator. In EP 1 956 229 A1, the applicant discloses such metal tube for the encapsulation of piezoelectric actuators wherein the metallic tube comprises strain compensation formations which can be extended parallel to the longitudinal axis and deflected inwardly transversally to the longitudinal axis of the piezoelectric actuator.

EP1854996 describes a piezoelectric actuator arrangement for a fuel injector that includes a corrugated metal enclosure surrounding the piezoelectric stack and containing a passivation fluid medium in contact with the stack. The corrugated metal enclosure can accommodate movement in transverse and longitudinal directions in response to temperature and pressure changes.

While this concept would provide a barrier to fuel and moisture, it is difficult to manufacture and it may be subject to fatigue breaking after a prolonged use.

Against this background, the main object of the present invention is to provide an alternative method of encapsulation that, when applied to a piezoelectric actuator, greatly reduces fuel (diesel/gasoline) and water permeation and thus improves the lifetime of piezoelectrically driven injectors.

### Summary of the Invention

This object is achieved by an actuator arrangement for use in a fuel injector, comprising: a piezoelectric actuator having a body section, said body section having a first end piece and a second end piece; a rigid encapsulation member which encloses the body section and the end pieces, wherein potting material is fitted between the rigid encapsulation member and the body section, wherein the first end piece is slideably fitted into the rigid encapsulation and the second end piece is fixed to or integrated into the encapsulation member.

The major advantage of the actuator arrangement according to the invention is to provide a piezoelectric actuator stack, which is easy to manufacture and has an improved fuel seal over time.

The slideably fitted first end piece enables the piezoelectric stack to expand and contract in a longitudinal direction, without damage, as it lengthens and contracts under voltages applied to the piezoelectric elements of the stack in use. The use of bellows or corrugated tubes as described in the above cited prior art thus becomes unnecessary since the compensation of the longitudinal movement is taken up by the slideable fitting of one of the end pieces.

The rigid encapsulation member comprises preferably a metallic tube, more preferably a steel tube. The walls of said steel tube is according to a preferred embodiment a thickness of between about 1,0 and 1.5 mm preferably of about 1.2 mm. Such a rigid encapsulation member does not yield or is not deformed in a substantial way under the pressures use in fuel injectors. Virtually no pressure is transmitted through the walls of the encapsulation member towards the stack.

The first end piece is preferably made of alumina whereas the second end piece is preferably made of metal and more preferably of steel of the quality: High Strength Low Alloy (HSLA) and is welded to the encapsulation member or integrated into the encapsulation member by to any other manufacturing process

The first end piece comprises according to a preferred embodiment an elastomeric seal member arranged between the first end piece and the rigid encapsulation member so that hydrostatic pressure can be applied to the potting material.

The elastomeric seal member comprises for example an O-Ring, which can be made of Viton® type fluoroelastomers. Viton fluoroelastomers are categorized under the ASTM D1418 & ISO 1629 designation of FKM. This class of elastomers is a family comprising copolymers of hexafluoropropylene (HFP) and vinylidene fluoride (VDF or VF2), terpolymers of tetrafluoroethylene (TFE), vinylidene fluoride (VDF) and hexafluoropropylene (HFP) as well as perfluoromethylvinylether (PMVE) containing specialties. The fluorine content of the most common Viton grades varies between 66 and 70%.

The first end piece is preferably slideably fitted such that it allows a movement in the longitudinal direction of the actuator arrangement from about 100 to 200 microns preferably of about the 150 micron due to stack actuation.

A potting material suitable for use with the invention is Fluorinert FC-43, although alternative minimally-compressive materials with similar properties may be used instead. Desirable properties of a dielectric filler fluid include: heat resistance; heat transfer ability, to absorb heat from the piezoelectric stack for transfer to the enclosure and from there to the fuel flowing around the enclosure; low water solubility; low viscosity; and low surface tension, to facilitate filling the intricate enclosure. Fluorinert FC-43 is a particularly useful selection as it has all of these properties and further, it is projected to compress by only 16% at 2000 bar.

### Brief Description of the Drawings

Embodiments of the present invention will now be described, by way of example only, with reference to the accompanying drawing, in which:

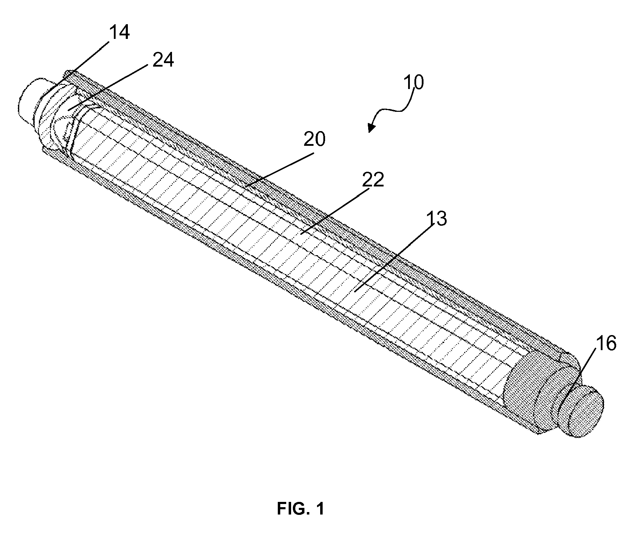

FIG. 1 is a perspective view of a piezoelectric actuator arrangement including a preferred embodiment of the present invention;

FIG. 1 shows an actuator arrangement 10, which is elongate and generally cylindrical in shape. The arrangement includes a known piezoelectric stack having at least one piezoelectric element (not shown), and is suitable for use in a fuel injector of an internal combustion engine.

The actuator 10 includes a generally cylindrical body section, comprising: a central major portion 13 containing a piezoelectric stack; and first and second end pieces 14 and 16 respectively. End piece 14, at the first end of body section, includes an electrical connector with first and second terminals, which in use receives a voltage from a voltage supply (not shown). End piece 16, at the second end of body section, includes a load transmitting member which in use cooperates with a control piston or valve needle (not shown) of the fuel injector.

Details of the piezoelectric stack and internal components of actuator 10 and a description of how the actuator operates are disclosed fully in the Applicant's granted patent EP 0995901, so will not be discussed here.

Evident from FIG. 1 is the presence of a rigid encapsulation member 20, a rigid steel tube, which envelops the body section and extends along the length of body section 12 from end piece 14 to end piece 16.

The rigid steel tube surrounds the body section and there is a gap between the stack and the steel tube, which results from the shape of the stack and the need to have manufacturing tolerances. Potting material 22 fills the gap and enables transmittal of the hydrostatic pressure from the fuel to the stack.

The first end piece 14 is slideably fitted into the rigid encapsulation member 20 and a seal 24 in the form of an O ring is provided between the steel tube and the end piece.

The seal 24 must be arranged in such a way that hydrostatic pressure can be applied to the potting material 20 in an axial direction, thus ensuring that the seal 24 is supported by the potting material 22 and that there is no air gap behind the seal 24. This allows a better seal to be created and to ensure that the potting material is axially compressed such that there can be efficient radial transmission of the hydrostatic pressure.

The slideable end piece 14 enables axial movement of the central portion 13 during use. The seal 24 is in itself flexible so as to allow a movement from about 100 to 200 microns preferably of about the 150 microns due to stack actuation and compensation of potting material compressibility (16% in case of Fluorinert FC-43).

At the second end, the steel tube is welded to the second end piece, the so called ball joint or integrated into the encapsulation member due to any other manufacturing process.

### Legend:

- 10: actuator arrangement
- 12: body section
- 13: central major portion
- 14: first end piece
- 16: second end piece
- 20: rigid encapsulation member
- 22: potting material
- 24: seal

## Claims

1. An actuator arrangement for use in a fuel injector, comprising: a piezoelectric actuator having a body section, said body section having a first end piece and a second end piece; a rigid encapsulation member which encloses the body section and the end pieces, wherein potting material is fitted between the rigid encapsulation member and the body section, wherein the first end piece is slideably fitted into the rigid encapsulation and the second end piece is fixed to the encapsulation member.

2. The actuator arrangement according to claim 1, wherein the rigid encapsulation member comprises a metallic tube.

3. The actuator arrangement according to claims 1 or 2, wherein the rigid encapsulation member comprises a steel tube.

4. The actuator arrangement according to claim 3, wherein the steel tube has a thickness of between about 1,0 and 1.5 mm preferably of about 1.2 mm.

5. The actuator arrangement according any of the claims 1 to 4, wherein the second end piece is made of metal and is welded to the encapsulation member.

6. The actuator arrangement according any of the claims 1 to 5, wherein said first end piece comprises a elastomeric seal member arranged between the first end piece and the rigid encapsulation member so that hydrostatic pressure can be applied to the potting material.

7. The actuator arrangement according to claim 6, wherein the elastomeric seal member comprises an O-ring.

8. The actuator arrangement according to claim 6 or 7, wherein the elastomeric seal member comprises Viton® type fluoroelastomers.

9. The actuator arrangement according to any of the claims 1 to 8, wherein the first end piece is slideably fitted such that it allows a movement in the longitudinal direction of the actuator arrangement from about 100 to 200 microns, preferably of about 150 microns.

10. The actuator arrangement according to any of the claims 1 to 9, wherein the first end piece is made of alumina.

## Amended claims

### Amended claims in accordance with Rule 137(2) EPC.

**1.** An actuator arrangement for use in a fuel injector, comprising: a piezoelectric actuator having a body section, said body section having a piezoelectric stack, a first end piece including an electrical connector and a second end piece; a rigid encapsulation member which encloses the body section and the end pieces, leaving a gap between the piezoelectric stack and the rigid encapsulation member, wherein potting material is fitted between the rigid encapsulation member and the body section so as to fill the gap and enable transmittal of the hydrostatic pressure from fuel surrounding the piezoelectric actuator to the stack, wherein the first end piece is slideably fitted into the rigid encapsulation and the second end piece is fixed to the encapsulation member.
